# EUROPEAN PATENT SPECIFICATION

(11) **EP 1 890 383 B1**
(45) Date of publication and mention of the grant of the patent: **27.05.2015**
(21) Application number: 07120947.2
(22) Date of filing: 14.04.2005
(51) Int. Cl.: H03M 3/04, H03J 7/04

(54) **A hybrid tuning circuit for continuous-time sigma-delta analog-to-digital converter**
Hybrideinstellungsschaltung für einen zeitkontinuierlichen Sigma-Delta-Analog-Digital-Umrichter
Circuit de réglage hybride pour convertisseur analogie-numérique sigma-delta en temps continu

(30) Priority: 29.06.2004 US 583756 P; 08.09.2004 US 936179
(43) Date of publication of application: 20.02.2008
(62) Divisional of application: 05737428.2
(73) Proprietor: Analog Devices, Inc., Norwood, MA 02062-9106 (US)
(72) Inventor: Nguyen, Khiem, Tewksbury, MA 01876 (US); Adams, Robert, Acton, MA 01720 (US)
(74) Representative: Beck, Simon Antony

(56) References cited:
- EP-A- 0 477 694
- US-A- 5 646 620
- US-A- 6 069 505
- US-A1- 2003 151 533
- XIA BO ET AL: "An auto-tuning structure for continuous time sigma-delta AD Converter and high precision filters" ISCAS 2002. PROCEEDINGS OF THE 2002 IEEE INTERNATIONAL SYMPOSIUM ON CIRCUITS AND SYSTEMS. SCOTTSDALE, AZ, MAY 26 - 29, 2002, IEEE INTERNATIONAL SYMPOSIUM ON CIRCUITS AND SYSTEMS, NEW YORK, NY : IEEE, US, vol. VOL. 5 OF 5, May 2002 (2002-05), pages 593-596, XP002342848 ISBN: 0-7803-7448-7
- LINDFORS S ET AL: "A 2.7V CMOS GSM/WCDMA continuous-time filter with automatic tuning" PROCEEDINGS OF THE IEEE 2001 CUSTOM INTEGRATED CIRCUITS CONFERENCE. (CICC 2001). SAN DIEGO, CA, MAY 6 - 9, 2001, IEEE CUSTOM INTEGRATED CIRCUITS CONFERENCE.CICC, NEW YORK, NY : IEEE, US, vol. CONF. 23, 6 May 2001 (2001-05-06), pages 9-12, XP010546837 ISBN: 0-7803-6591-7

## Description

### FIELD OF INVENTION

This invention relates to mixed-signal converters of the sigma-delta noise shaping type, and more particularly, to mixed-signal analog-to-digital converter that employs a hybrid continuous-time and discrete-time circuit.

### BACKGROUND OF THE INVENTION

Sigma-delta analog-to-digital converters (ADCs) provide for a means to achieve high resolution and low distortion at a relatively low cost compared to traditional Nyquist converters. The high resolution is achieved by oversampling the input signal and shaping the quantization noise in the band of interest into higher frequency region. The higher frequency noise can then be digitally filtered out by the subsequent digital filter stages. The resulting data is then down sampled to the desired sample rate at the output of the converter.

Typically, an audio sigma-delta ADC is implemented using discrete-time circuits such as switched capacitors for the following reasons. Switched capacitor circuits, typically used in the implementation of the first integrator, offer low sensitivity to clock jitter and is readily scalable with sampling rate. Moreover, tracking of coefficients is inherently good due to good matching of capacitors. However, due to the discrete-time nature, the converter suffers from harmonic distortion primarily caused by signal-dependent glitches captured by the sampling capacitors of the first integrator. In highly-integrated circuits such as a digital signal processor (DSP) with on-chip converters, it is very difficult to contain these undesirable glitches since the DSP is running at a much higher clock rate than the converter. Furthermore, for high performance converters, over 100dB of signal-to-noise ratio (SNR), the sampling capacitors have to be large to reduce the thermal noise. When such large capacitors sample the input voltage, they emit current glitches back into the signal source which leads to electromagnetic interference (EMI).

Instead of implementing the first integrator by switched capacitors, the integrator can be implemented using real resistors and capacitors, such as in the implementation of a continuous-time integrator. The U.S. patent to Sooch et al. (5,079,550), hereinafter Sooch, provides for such a combination of continuous-time and discrete integrators in a sigma-delta ADC.

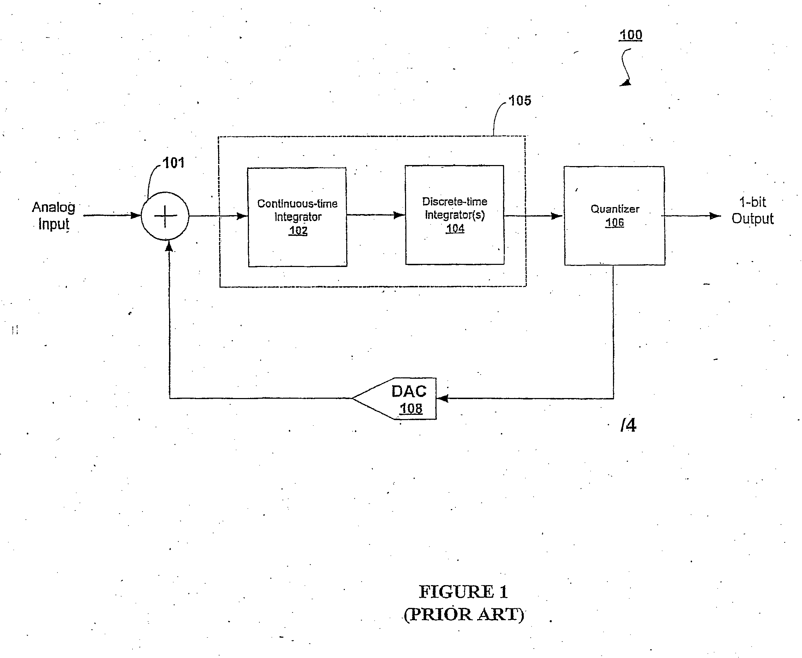

Figure 1 illustrates a block diagram outlining Sooch's setup **100** comprising summer circuit **101,** continuous-time integrator **102,** discrete-time integrator(s) **104,** quantizer **106,** and current feedback digital-to-analog converter (DAC) **108.** An analog input signal is connected to the positive input of a summing circuit or summer 101,' with the output of summer 101 being connected to the input of loop filter 105, which is also the input to the continuous-time integrator 102. The output of the continuous-time integrator 102 is converted to a discrete-time signal. Connected to the other side of continuous-time integrator **102** is a discrete time integrator **104,** wherein the output of the discrete time integrator 104 forms the output of the analog loop filter **105** and is connected to the input of quantizer **106,** which, in this example, is a one bit analog-to-digital converter. The output of quantizer **106** forms the output and also forms the input to DAC **108,** with the output of DAC **108** being connected to the negative input of summer **101.**

Due to the nature of the continuous-time setup of the first stage, any glitches happening in the first stage are averaged out over the clock period instead of being sampled. Hence, the negative effect of these glitches on the performance of the converter is greatly reduced. This is a major advantage of continuous-time versus discrete-time implementations. Moreover, since the input impedance is purely resistive (if the feed forward path from the input is eliminated), the circuit does not emit high frequency current glitches back to the external source. The setup of Sooch yields a much lower electromagnetic interference (EMI) compared to a switched capacitor implementation. But, the Sooch setup of figure 1 suffers from various pitfalls, some of which are addressed below.

A major drawback associated with the combination of continuous-time and discrete-time implementation described above is that the RC time constant, or integrator gain varies significantly with process, temperature, and power supply variation. Variation in the RC product changes the noise transfer function of the loop and leads to degradation in performance of the converter.

Another disadvantage associated with such an implementation is that the RC time constant also changes with the period of the master clock of the converter which clocks the switched-capacitor network in the second stage. This essentially limits the converter operation to one particular sampling rate.

Yet another disadvantage associated with the continuous-time implementation is that the continuous-time feedback DAC has inter-symbol-interference (ISI) which dominates the harmonic distortion of the overall performance of the ADC.

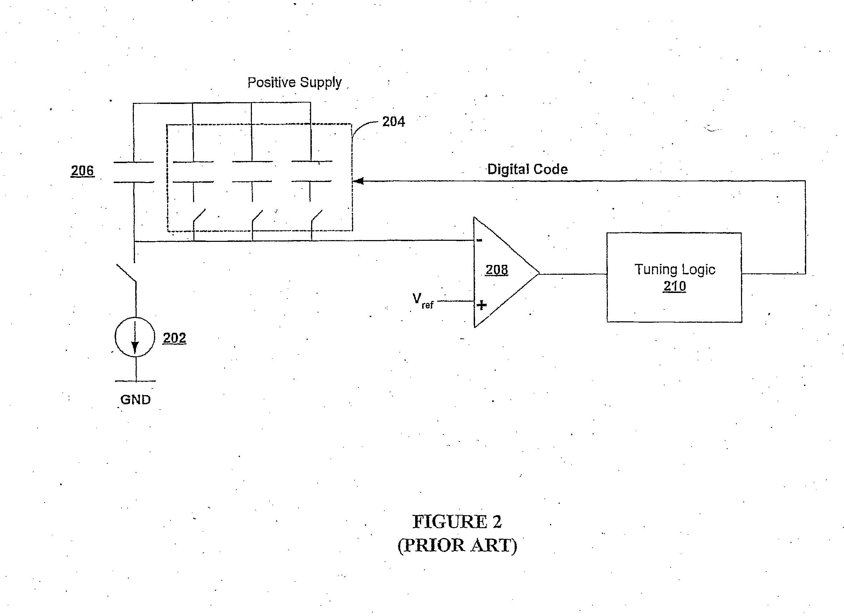

An attempt to solve this problem was presented in the article by Xia et al. entitled, "An automatic tuning structure for continuous-time sigma-delta ADC and high precision filters". Xia et al. addressed stabilizing the RC product via a discrete tuning approach. Figure 2 illustrates a simplified diagram of the prior art tuning technique as taught by Xia et al. The setup of figure 2 comprises reference current source **202,** programmable capacitor bank **204,** fixed capacitor **206,** comparator **208,** and tuning logic circuit 210. By calibrating the voltage at the capacitor output to a fixed voltage, the circuit produces a control code that will control both the programmable capacitor array of the tuning circuit and the programmable capacitor array of the first stage continuous-time integrator. Xia's technique suffers from a disadvantage with respect to the coarse quantization step size of the counter, which is not suitable for high precision sigma-delta ADCs. Furthermore, the use of programmable capacitor array **204** also limits the tuning to a narrow range, hence not suitable for the large variation of sampling rate required in audio ADCs.

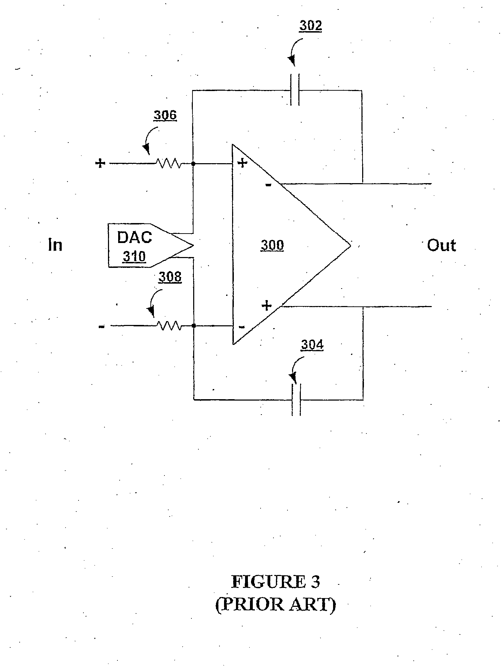

Figure 3 shows a conventional differential implementation of a continuous-time first stage in a sigma-delta ADC. It consists of an amplifier **300,** a pair of capacitors **302, 304,** a pair of input resistors **306, 308,** and a feedback DAC, **310.** In normal operation mode, the input voltage is converted to current via the input resistors **306, 308.** The feedback DAC **310** is controlled by the digital output of the converter. As mentioned before, the low frequency content of the digital output tracks with the input. Hence, the error current, the difference between the input current and the output of the DAC, is mostly high frequency shaped noise. This noise is integrated by the capacitors **302, 304** and then sampled by the subsequent switched capacitor integrator.

Whatever the precise merits, features, and advantages of the above discussed prior art implementations, none of them achieves or fulfils the purposes of the present invention.

EP 0477694 discloses a continuous time tuning circuit. A transistor is provided in conjunction with a feedback circuit to vary the resistance of the transistor to fine tune a filter.

### SUMMARY OF THE INVENTION

According to the present invention there is provided a continuous-time integrator comprising:
a digital-to-analog converter (DAC);
a plurality of input resistors;
a differential operational amplifier; characterized by:
   a first fixed capacitor connected to a non-inverting input of the differential operational amplifier and to a first output of the differential operational amplifier;
   a second fixed capacitor connected to an inverting input of the differential operational amplifier and to a second output of the differential operational amplifier;
   a plurality of programmable capacitor arrays, a first programmable capacitor array connected to the first fixed capacitor and a second programmable capacitor array connected to the second fixed capacitor;
   a plurality of switches controllable via a hybrid tuning circuit;
   said hybrid tuning circuit further comprising an analog control circuit comprising a hybrid tuning circuit programmable capacitor array and a second plurality of switches to generate and adjust an integration control signal via controlling said first plurality of switches;
   said integration control signal controlling an integration time of said continuous-time integrator; and
   a finite state machine monitoring said integration control signal, said finite state machine decrementing and incrementing capacitor size in said first, second, and hybrid tuning circuit programmable capacitor arrays;
   wherein said first plurality of switches either connect said input resistors and differential DAC outputs to respective summing junctions at respective differential inputs of said operational amplifier during an integration period, or said first plurality of switches disconnect said resistors and said differential DAC outputs from said operational amplifier and connect said input resistors and said differential DAC outputs to a known voltage (V_{ref}).

### BRIEF DESCRIPTION OF THE DRAWINGS

Figure 1 illustrates the prior art of a combination continuous-time and discrete- time implementation of a sigma-delta ADC.
Figure 2 shows a prior art discrete tuning technique.
Figure 3 shows a conventional differential implementation of a continuous-time integrator.
Figure 4 shows the block diagram of a 4-bit sigma-delta analog-to-digital converter with a continuous-time first-stage in this invention.
Figure 5 illustrates an exemplary embodiment of the present invention, wherein the depicted circuit eliminates the above-mentioned problems with respect to the prior art.
Figure 6 illustrates an exemplary embodiment of the tuning circuit's digital finite state machine.
Figure 7 illustrates an exemplary embodiment of the analog control circuit.
Figure 8 illustrate a timing diagram depicting the switching scheme.
Figure 9 illustrates a graph of the integrator voltage versus the integration time.

### DETAILED DESCRIPTION OF THE INVENTION

Although the present invention has been shown and described with respect to several preferred embodiments thereof, various changes, omissions and additions to the form and detail thereof, may be made therein, without departing from the spirit and scope of the invention.

The present invention uses a hybrid tuning circuit comprising a digital finite state machine and an analog control circuit to effectively keep the RC product of the continuous time integrator constant across process, temperature, supply and sampling rate variations. Because the present invention's implementation is continuous in nature, the tracking is much more accurate than traditional techniques mentioned before. Moreover, the present invention allows for a wide variation of sampling rate which is not possible in prior arts.

According to a further aspect of the present invention, a carefully chosen clocking scheme is provided, wherein the scheme eliminates the inter-symbol-interference (ISI) in the feedback DAC which is a major pitfall associated with prior art continuous time ADC designs. It should be noted that the present invention's technique does not use a reference frequency for calibration, thereby eliminating the need for a user to identify a this reference

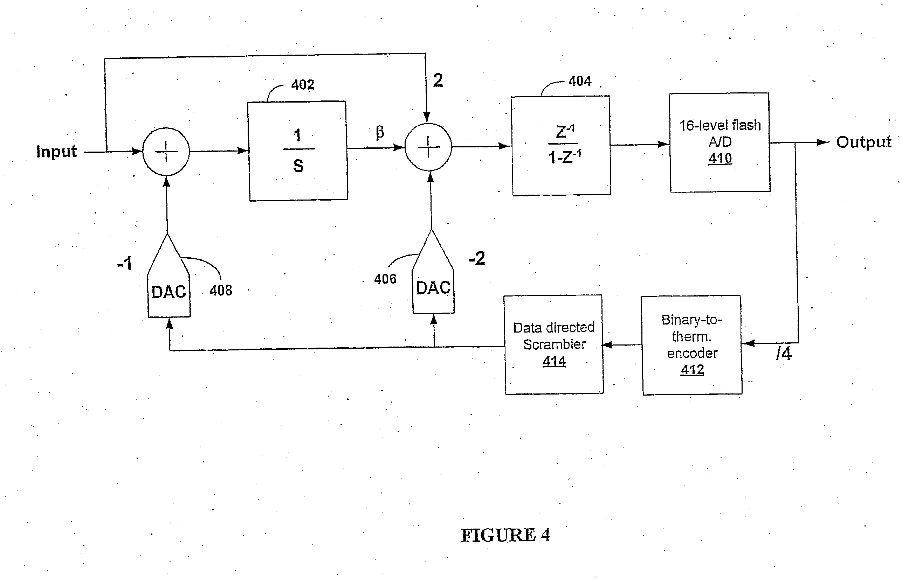

Figure 4 illustrates a simplified model of a 4-bit, 2^{nd}-order sigma delta analog-to-digital converter with a continuous-time first-stage used in this invention. The setup primarily comprises continuous-time integrator **402,** switched' capacitor DAC **406,** switched capacitor integrator **404,** current steering DAC **408;** a 16-level flash ADC **410,** a binary-to-thermometer code encoder **412,** a data-directed scrambler **414.**

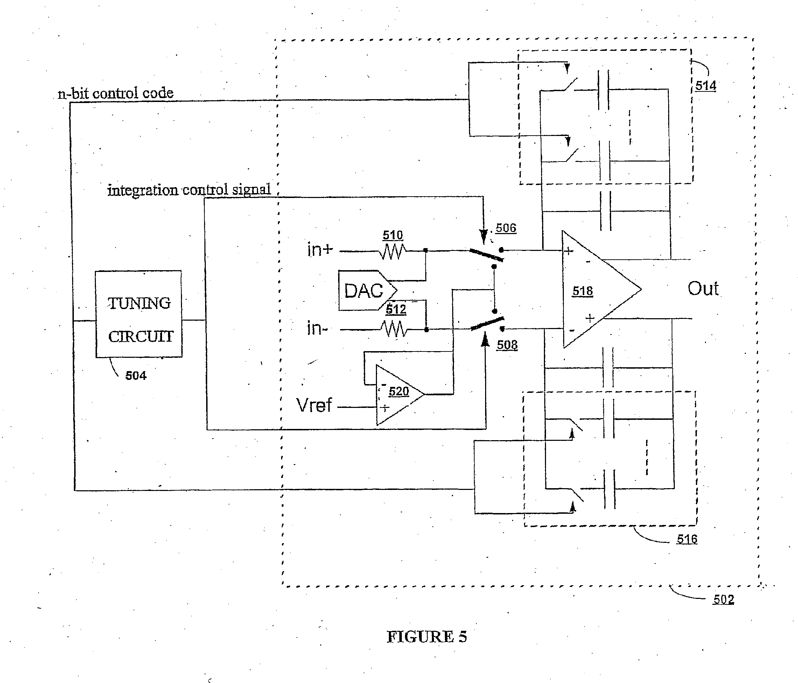

Figure 5 illustrates an exemplary embodiment of the present invention, wherein circuit 500 of Figure 5 eliminates the above-mentioned problems with respect to the prior art. Circuit **500** consists of two sections: a modified continuous-time integrator **502** and a tuning circuit **504.** The said modified continuous-time integrator has a pair of switches **506** and **508** in series with input resistors **510** and **512,** an amplifier **518,** DAC **526,** and a voltage buffer **520.** The switches **506** and **508** are controlled by the tuning circuit **504.** The programmable capacitor arrays 514 and 516 are also controlled by the tuning circuit **504.**

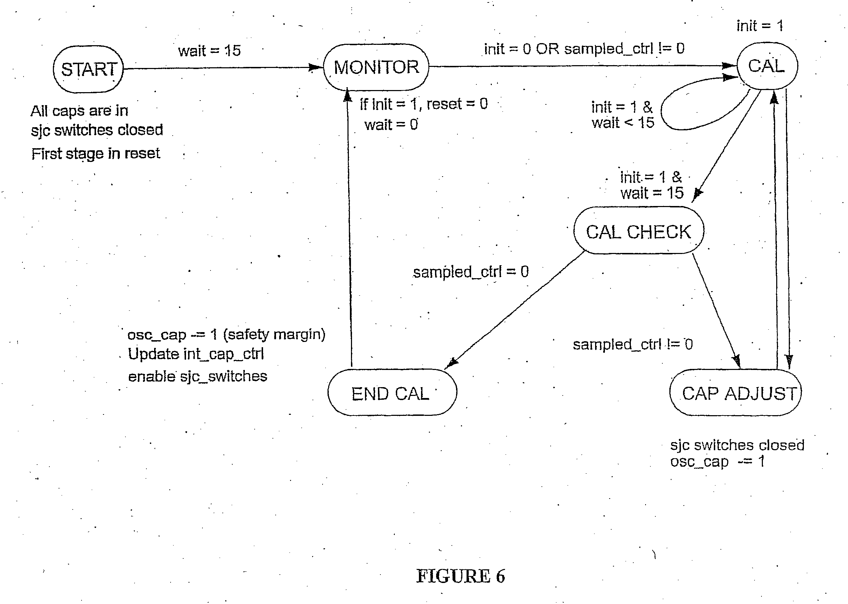

The tuning circuit **504** comprises a finite state machine and an analog control block. Figure 6 illustrates an exemplary embodiment of tuning circuit **304's** finite state machine. The finite stage machine comprises of several D flip-flops and combinational logics to perform the task described by the flow chart in Figure 4, a 4-bit binary counter to control the capacitor arrays in the analog tuning circuit and also the capacitor arrays in the said continuous-time integrator. The implementation of the finite state machine can be either in a hardware description language or simply by manual design.

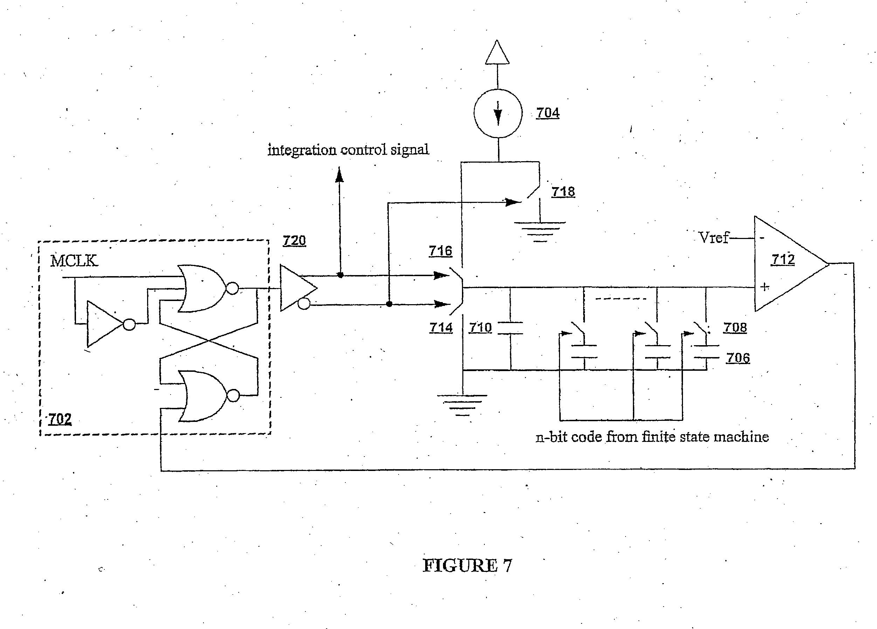

Figure 7 illustrates an exemplary embodiment of the analog control circuit described above. The analog control circuit consists of a pulse generator combined with a RESET-SET (RS) flip flop **702,** a current source **704** biased by the same bias voltage of the DAC, an array of programmable capacitors **706,** an array of switches **708,** a fixed capacitor **710,** a comparator **712,** a pair of switches **714, 716,** a shunt switch **718.** The ratio of the sum of the programmable capacitors to the fixed capacitor is identical to those in the modified continuous-time integrator **502.** Both the programmable capacitor arrays in the tuning circuit and the said continuous-time integrator are controlled by the same digital code from the finite stage machine. The input of the analog circuit consists of the master clock, the clock of the overall ADC, the digital code from the said finite stage. The analog control circuit produces an integration control signal which controls the switches **506** and **508** of Figure 5.

Returning to the discussion of Figure 5; a goal is to change the integration period, the period when the two switches **506** and **508** in the integrator are closed, proportionally to the change of the RC product so that the final voltage at the integrator output is constant in the presence of process, power supply, temperature, and sampling rate variations. This action is accomplished automatically in the analog control circuit by increasing or decreasing the integration control signal. Another goal is to cut down the feedback capacitors **(514** and **516)** in the integrator according to the instruction from the tuning circuit **504's** finite state machine.

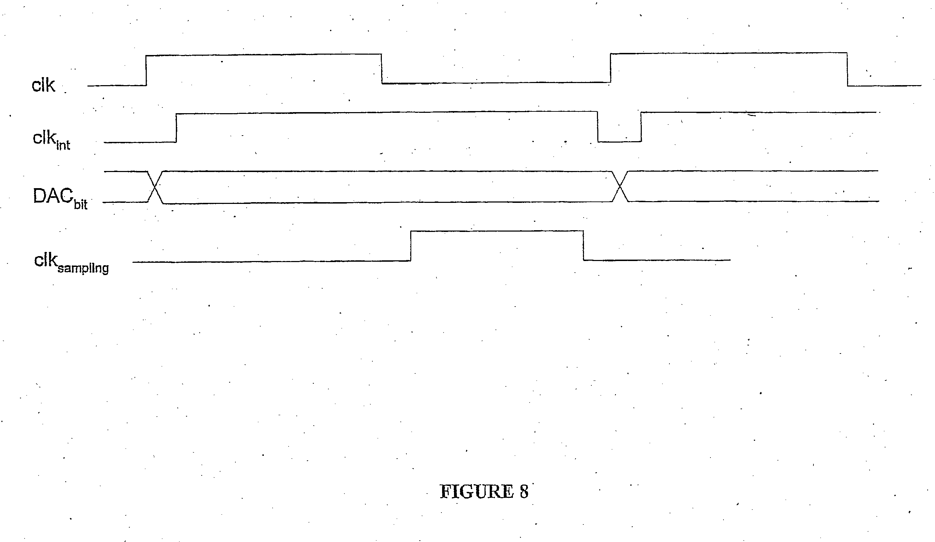

The operation of the tuning circuit can be described as follow. On power up, the analog control circuit is in reset state. In this state, the comparator output is at 0, all the capacitors in the control circuit 500 and the integrator 502 are switched in, and both of the switches **506** and **508** in the integrator are closed. This configuration creates an un-tuned continuous-time integrator. When the reset signal is de-asserted, the tuning circuit **504** will be functional. Figure 8 illustrates this scenario. On the rising edge of the master clock, the pulse generator creates a pulse which triggers the RESET-SET flip-flop circuit. The output of the flip-flop then turns on the two switches **506** and **508** in the continuous-time integrator which start the integration period. At the same time, the scaled current source **704** (of figure 7) starts to charge up the capacitors. When the voltage at the output of the capacitor array crosses the threshold of the comparator, the comparator will trip. It then resets the RS flip flop and ends the integration period. Switch **714** then discharges the voltage on the capacitors in the tuning circuit. During this time, switch 718 connects the output of the current source 704 to ground, thus discharges any voltage captured by the parasitic capacitor at that node.

The analog control circuit in Figure 7 is designed such that the integration period ends before the next rising edge of the clock. During the non-integrating time, the time when both switches in the integrator are opened, the DAC bits can change to the next value (as shown in figure 8). When the next integration period commences, the DAC bits have already been set to the proper value. This means the integrator has no memory of the previous data of the DAC. Hence, the integrator is free of inter-symbol-interference. Those who are skilled in the art can think of this as a return-to-zero scheme applying on the error signal, the difference between the feed-in and feedback current. The benefit of this scheme are as follow: (a) the RTZ is applied on the small error signal which flows through the switches in the integrator, hence, it does not present any additional stress to the operational amplifier in the integrator; and (b) the switches do not conduct any signal related current hence, do not cause distortion to the converter performance. This is a major advantage compared to traditional RTZ on DAC only implementation.

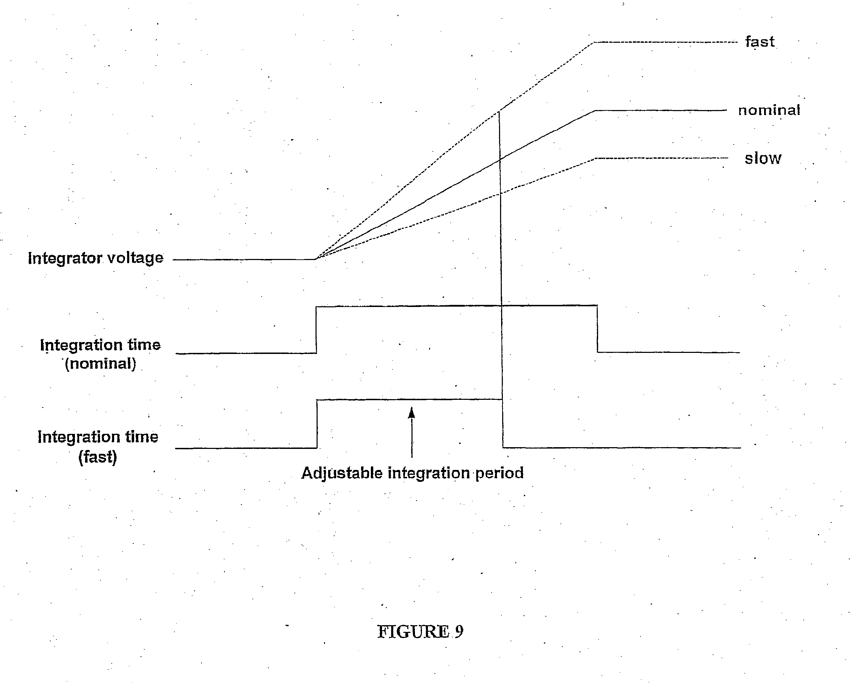

The finite state machine of figure 6 constantly monitors the integration control signal. In the event where the capacitors are smaller than nominal due to process variation, the voltage at the output of the capacitor array in the analog control circuit will reach the threshold of the comparator earlier than normal. The output of the integrator will also rise faster than normal. But when the comparator trips, it shortens the integration period. Therefore, the final voltage at the integrator output is still the same as in the normal case; this scenario is illustrated in Figure 9.

In the event where the capacitors are larger than normal due to process variation, the voltage at the output of the capacitor array in the analog control circuit will reach the threshold voltage later than normal. The output of the integrator will also rise slower than normal. Therefore, it takes longer for the comparator to trip. The integration period becomes longer than normal. The tuning circuit tracks continuously until the integration period becomes longer than one clock period. When this happens, the finite state machine will decrement the programmable capacitor array in the analog control circuit. It will continue to do so until the integration period is shorter than one clock period. At this point, the tuning circuit will change the programmable capacitors in the continuous-time integrator to the same code as used in the analog control circuit. The upper limit of the sampling rate variation is therefore, the ratio between the programmable capacitor array to the sum of programmable and fixed capacitors in the tuning circuit.

After the calibration is completed, the tuning circuit will be in a monitor state where it continuously examines the integration control signal and restarts calibration if necessary. To ensure un-interrupted operation for the continuous-time integrator, the switches **506** and **508** are always closed during calibration. Also, the capacitor arrays in the continuous-time integrator are only updated at the end of the calibration cycle.

## Claims

1. A continuous-time integrator comprising:
a digital-to-analog converter (DAC);
a plurality of input resistors (510, 512);
a differential operational amplifier (518); **characterized by**:
a first fixed capacitor connected to a non-inverting input of the differential operational amplifier (518) and to a first output of the differential operational amplifier (518);
a second fixed capacitor connected to an inverting input of the differential operational amplifier (518) and to a second output of the differential operational amplifier (518);
a plurality of programmable capacitor arrays (514, 516), a first programmable capacitor array (514) connected to the first fixed capacitor and a second programmable capacitor array (516) connected to the second fixed capacitor;
a plurality of switches (506, 508) controllable via a hybrid tuning circuit (504);
said hybrid tuning circuit (504) further comprising an analog control circuit comprising a hybrid tuning circuit programmable capacitor array (706) and a second plurality of switches (708) to generate and adjust an integration control signal via controlling said first plurality of switches (506, 508);
said integration control signal controlling an integration time of said continuous-time integrator; and
a finite state machine monitoring said integration control signal, said finite state machine decrementing and incrementing capacitor size in said first (514), second (516), and hybrid tuning circuit (706) programmable capacitor arrays;
wherein said first plurality of switches (506, 508) either connect said input resistors (510, 512) and differential DAC outputs to respective summing junctions at respective differential inputs of said operational amplifier (518) during an integration period, or said first plurality of switches (506, 508) disconnect said resistors (510, 512) and said differential DAC outputs from said operational amplifier (518) and connect said input resistors (510, 512) and said differential DAC outputs to a known voltage (V_{ref}).

2. A continuous-time integrator, as per claim 1, wherein said first plurality of switches (506, 508) are closed proportionally to a change in a RC product such that the final voltage at said continuous-time integrator is constant in the presence of process, power supply, temperature, and sampling rate variations.

3. A continuous-time integrator, as per claim 2, wherein said first plurality of switches (506, 508) are closed proportionally via increasing said integration control signal.

## Patentansprüche

1. Zeitkontinuierlicher Integrator, der umfasst:
einen Digital/Analog-Umsetzer (DAC);
mehrere Eingangswiderstände (510, 512);
einen differentiellen Operationsverstärker (518); **gekennzeichnet durch**:
einen ersten festen Kondensator, der mit einem nicht invertierenden Eingang des differentiellen Operationsverstärkers (518) und mit einem ersten Ausgang des differentiellen Operationsverstärkers (518) verbunden ist;
einen zweiten festen Kondensator, der mit einem invertierenden Eingang des differentiellen Operationsverstärkers (518) und mit einem zweiten Ausgang des differentiellen Operationsverstärkers (518) verbunden ist;
mehrere programmierbare Kondensatoranordnungen (514, 516), wobei eine erste programmierbare Kondensatoranordnung (514) mit dem ersten festen Kondensator verbunden ist und eine zweite programmierbare Kondensatoranordnung (516) mit dem zweiten festen Kondensator verbunden ist;
eine Mehrzahl von Schaltern (506, 508), die über eine Hybridabstimmschaltung (504) steuerbar sind;
wobei die Hybridabstimmschaltung (504) ferner eine analoge Steuerschaltung umfasst, die eine programmierbare Hybridabstimmschaltung-Kondensatoranordnung (706) und eine zweite Mehrzahl von Schaltern (708) umfasst, um über die Steuerung der ersten Mehrzahl von Schaltern (506, 508) ein Integrationssteuersignal zu erzeugen und einzustellen;
wobei das Integrationssteuersignal eine Integrationszeit des zeitkontinuierlichen Integrators steuert; und
einen endlichen Automaten, der das Integrationssteuersignal überwacht, wobei der endliche Automat die Kondensatorgröße in der ersten Kondensatoranordnung (514), der zweiten Kondensatoranordnung (516) und der programmierbaren Hybridabstimmschaltung-Kondensatoranordnung (706) dekrementiert und inkrementiert;
wobei die erste Mehrzahl von Schaltern (506, 508) entweder während einer Integrationsperiode die Eingangswiderstände (510, 512) und differentielle DAC-Ausgänge mit entsprechenden Summationsverbindungspunkten an entsprechenden differentiellen Eingängen des Operationsverstärkers (518) verbinden oder wobei die erste Mehrzahl von Schaltern (506, 508) die Widerstände (510, 512) und die differentiellen DAC-Ausgänge von dem Operationsverstärker (518) trennen und die Eingangswiderstände (510, 512) und die differentiellen DAC-Ausgänge mit einer bekannten Spannung (V_{ref}) verbinden.

2. Zeitkontinuierlicher Integrator nach Anspruch 1, wobei die erste Mehrzahl von Schaltern (506, 508) proportional zu einer Änderung eines RC-Produkts geschlossen wird, derart, dass die endgültige Spannung bei dem zeitkontinuierlichen Integrator in Gegenwart von Prozess-, Stromversorgungs-, Temperatur- und Abtastraten-Veränderungen konstant ist.

3. Zeitkontinuierlicher Integrator nach Anspruch 2, wobei die erste Mehrzahl von Schaltern (506, 508) proportional zu einer Zunahme des Integrationssteuersignals geschlossen wird.

## Revendications

1. Intégrateur en temps continu, comprenant :
- un convertisseur numérique-analogique (DAC) ;
- une pluralité de résistances d'entrée (510, 512) ;
- un amplificateur opérationnel différentiel (518),
**caractérisé par** :
- un premier condensateur fixe qui est connecté à une entrée de non-inversion de l'amplificateur opérationnel différentiel (518) et à une première sortie de l'amplificateur opérationnel différentiel (518) ;
- un second condensateur fixe qui est connecté à une entrée d'inversion de l'amplificateur opérationnel différentiel (518) et à une seconde sortie de l'amplificateur opérationnel différentiel (518) ;
- une pluralité de réseaux de condensateurs programmables (514, 516), un premier réseau de condensateurs programmables (514) étant connecté au premier condensateur fixe, et un second réseau de condensateurs programmables (516) étant connecté au second condensateur fixe ;
- une pluralité de commutateurs (506, 508) commandés par un circuit de syntonisation hybride (504) ;
- ledit circuit de syntonisation hybride (504) comprenant en outre un circuit de commande analogique comprenant un réseau de condensateurs programmables de circuit de syntonisation hybride (706) et une seconde pluralité de commutateurs (708) pour générer et régler un signal de commande d'intégration en commandant ladite première pluralité de commutateurs (506, 508) ;
- ledit signal de commande d'intégration commandant un temps d'intégration dudit intégrateur en temps continu ; et
- une machine à états finis surveillant ledit signal de commande d'intégration, ladite machine à états finis décrémentant et incrémentant la taille de condensateur dans le premier (514) et le second (516) réseaux de condensateurs programmables et le réseau de condensateurs programmables de circuit de syntonisation hybride (706) ;
dans lequel ladite première pluralité de commutateurs (506, 508) connecte soit lesdites résistances d'entrée (510, 512) et les sorties DAC différentielles à des jonctions de sommation respectives à des entrées différentielles respectives dudit amplificateur opérationnel (518) pendant une période d'intégration, soit ladite première pluralité de commutateurs (506, 508) déconnecte lesdites résistances (510, 512) et lesdites sorties DAC différentielles dudit amplificateur opérationnel (518) et connecte lesdites résistances d'entrée (510, 512) et lesdites sorties DAC différentielles à une tension connue (V_{ref}).

2. Intégrateur en temps continu selon la revendication 1, dans lequel ladite première pluralité de commutateurs (506, 508) est fermée de façon proportionnelle à une variation dans un produit RC de telle sorte que la tension finale audit intégrateur en temps continu soit constante en présence de variations du procédé, de l'alimentation électrique, de la température et de la vitesse d'échantillonnage.

3. Intégrateur en temps continu selon la revendication 2, dans lequel ladite première pluralité de commutateurs (506, 508) est fermée de façon proportionnelle en augmentant ledit signal de commande d'intégration.
